# EUROPEAN PATENT SPECIFICATION

(11) **EP 4 240 124 B1**
(45) Date of publication and mention of the grant of the patent: **21.05.2025**
(21) Application number: 22159428.6
(22) Date of filing: 01.03.2022
(51) Int. Cl.: H05K 7/14

(54) **WALL MOUNT RACK FOR ELECTRONIC EQUIPMENT**
WANDHALTERUNG FÜR ELEKTRONISCHE GERÄTE
RACK DE MONTAGE MURAL POUR ÉQUIPEMENT ÉLECTRONIQUE

(43) Date of publication of application: 06.09.2023
(73) Proprietor: EFB-Elektronik GmbH, 33719 Bielefeld (DE)
(72) Inventor: SÖRENSEN, Kim H., 2760 Malov (DK); SCHMIDT, Kristian Kjaerholt, 4390 Vipperød (DK)
(74) Representative: Schober, Mirko

(56) References cited:
- EP-A1- 3 780 920
- CN-U- 205 320 434
- GB-A- 2 569 525
- JP-A- 2005 045 056
- JP-A- 2016 184 686
- US-A1- 2007 144 982
- US-A1- 2013 213 907

## Description

The invention relates to a wall mount rack system, in particular 19-inch wall mount rack system, for accommodating electronic and/or network equipment modules according to the preamble of claim 1. Furthermore, the invention relates to a wall mount rack assembled by using said wall mount rack system.

Racks of this type a stationary enclosure for accommodating electronic and/or network equipment modules. These modules usually have lateral mounting elements which allow the module to be fastened to a part of the framework of the rack, for example by bolting or clipping. Typical areas of application for said racks include data centers, laboratories and studios as well as any kind of offices up to home use. Here, 19-inch systems, which serve to accommodate modules or entire assemblies with a standardized width of 19 inches, have essentially become established.

CN 206 698 542 U discloses a wall mount rack for electronic and/or network equipment modules. This wall mount rack is based on a framework to support some cover arrangements, namely a left side cover arrangement and a right side cover arrangement as well as a top cover arrangement and a bottom cover arrangement. The so build cabinet has an interior space which can be opened and closed by a door which is hinged to the framework.

Depending on the dimensions of such a rack, transport and storage of an assembled rack can require large space. Therefore, the racks are often stored and delivered in a disassembled state to save transporting space Because of the many individual parts involved, the assembly of the rack can be complicated and thus time-consuming. Because of the large number of possible modules to be accommodated inside the rack and their depth dimensions, standardized racks are often either undersized or oversized with respect to the amount and size of the modules the racks are intended to accommodate.

JP 2005 045056 A discloses a rack system for various communication devices, broadcasting devices and the like, and therefore for electronic and/or network equipment modules. The framework of the rack comprises a front frame and a rear frame, joined by a depth frame. The depth frame is divided, wherein his parts are pivotably jointed to the frames and with each other through hinges in such that the parts of the depth frame can be folded to approximate the front frame and the rear frame to each other.

US 2007/144982 A1 discloses a cabinet configured as an equipment rack for a telecommunications infrastructure and therefore at least for electronic equipment modules. The cabinet can be configured with an open frame housing as opposed to an enclosure with doors and so forth. The rack also comprises a framework as a support for angled cover arrangements, each showing a wide side surface with an in contrast shorter angled mounting surface.

GB 2 569 525 A discloses a rack system for computer and server system components and therefore for electronic and/or network equipment modules. The rack system comprises a center body section having an internal framework as a support for cover arrangements as well as a hinged door to build a cabinet which limits an interior space.

Aside from the setbacks mentioned above, the prior art, especially JP 2005 045056 A, does perform unsatisfactorily when it comes to packaging size whenever the framework is folded together.

The object of the invention to provide an improved rack that offers a certain degree of flexibility as a response to the above mentioned setbacks and creates a wall mount rack system such that the smallest possible packaging size is achieved.

According to the invention, this object is achieved by providing a wall mount rack system comprising the features of claim 1. Favorable embodiments are the subject of dependent claims 2 to 6. Furthermore, the object is also achieved by a wall mount rack, more particularly a server or network wall mount rack, comprising the features of claim 7.

The core of the invention is that the framework and the cover arrangements are designed to be flexible in size. This means that at least a depth of the so limitable interior space of the cabinet can be varied. Accordingly, the framework as well as the cover arrangements are designed to be customized in size before the rack system is actually assembled to become a rack, and/or when said rack system has been fully assembled and/or is being assembled.

The wall mounted rack system according to the invention therefore offers, due to its dimensional flexibility, a maximum adaptability to the respective current conditions or needs during its entire service time.

According to the invention, the framework has a base frame as well as a first left side frame and a first right side frame. Thereby, each of said side frames is hinged to the base frame. Furthermore, the base frame is designed to attach the framework to a wall or the like, wherein each hinged side frame is intended to be swung in and to be swung out relative to said base frame. This enables for the side frames to be swung in - for example during a transport and/or storage of the framework- whereas the side frames are capable of being swung out, e.g. for serving their purpose of supporting at least partially one of the associated side cover arrangements and/or an associated top cover arrangement and/or an associated bottom cover arrangement. This results in the smallest possible packing size for transporting and storage purposes. At the same time, the hinged side frames allow for an extremely simple assembly of the framework.

The framework does also include a second left side frame as well as a second right side frame. Said second left side frame is slidably couplable to said first left side frame, wherein said second right side frame is slidably couplable to said first right side frame. As a result, each second side frame is designed to be quasi-telescopic relative to the associated first side frame.

This entails that the depth of the interior space may be varied to support different sized electronic and/or network equipment modules. At the same time, the external dimension of the entire cabinet can be held as small as possible in terms of its depth, as this depends only on the depth of the largest module to be incorporated within the cabinet.

Said first side frames and said second side frames each comprise two arms and a crossbar connecting said arms of each side frame to one another. Said arms of each side frame extend parallel to each other. The arms of each side frame are designed for being slidably coupled with the arms of the associated side frame.

Furthermore, the arms of each first side frame may have a U-shaped cross section, at least in sections and/or regions thereof. In addition, the arms of each second side frame may then be designed such that each of said arms can be arranged at least partially in the U-shaped cross section of an arm of the associated first side frame. Based on this, the legs of each U-shaped cross section of the arms of the first side frames act as supports to linearly guide the arms of the second side frames so as to prevent e.g. canting of the touching side frames during a relative movement.

According to a preferred embodiment, each arm of said first side frames of the wall mount rack system could be equipped with or prepared to receive an at least partially releasable connection means. Each arm of said second side frames comprises an elongated slit with a widened hole-like zone. Each hole-like zone is designed to allow a head of one of the connection means to pass therethrough such that - upon movement of a second side frame relatively to an associated first side frame - an portion of said connection means, being smaller than said head, can at least partially slide inside the elongated slit of the arm of the second side frame. At the same time, a portion of said arm of the second side frame defining respectively limiting the elongated slit can at least be partially guided between the arm of the first side frame and the head of said connection means.

This prevents unintentional decoupling of the respective second side frame from its associated first side frame while allowing these parts to move relatively to each other in a linear manner.

In this context, it could come in handy, if a movement of a second side frame relatively to an associated first side frame can be prevented by manipulating at least one of said connection means of the U-shaped arm of the first side frame. This manipulation may be carried out such that the associated strip-shaped arm of the particular second side frame is thereby partially clamped between the U-shaped arm of said particular first side frame and said head of this connection means. For example, the connecting means could be embodied as a screw or a bolt, which is screwed into the U-shaped arm of said first side frame for an appropriate distance for this purpose.

Preferably, the left side cover arrangement has a first left side cover as well as a second left side cover, wherein the right side cover arrangement could have a first right side cover as well as a second right side cover. Each first side cover is designed to be coupled with the associated first side frame and each second side cover is designed to be coupled with the associated second side frame. These couplings are such that each second side cover is able to be moved parallel to the associated first side cover during telescoping of the associated second side frame with respect to the associated first side frame.

Advantageously, this can be achieved during telescoping of the framework, by the associated side covers sliding over each other, at least in certain areas. Thus, it is always possible to cover the sides of the cabinet without gaps.

According to a further embodiment of the present invention, the top cover arrangement may have a first top cover as well as a second top cover, wherein the bottom cover arrangement may have a first bottom cover as well as a second bottom cover. In this embodiment, the first top cover as well as the first bottom cover are designed to be coupled with the associated first side frames, wherein the second top cover as well as the second bottom cover are designed to be coupled with the associated second side frames. Said couplings such that the second top cover is able to be moved parallel to the first top cover, wherein the second bottom cover is able to be moved parallel to the first bottom cover. This possible movement then happens simultaneously for both the first top cover and the first bottom cover during telescoping both second side frames with respect to the associated first side frames.

Preferably, this can carried out such that during telescoping of the framework, the top covers and the bottom covers slide over each other, at least in certain areas. Thus, it is always possible to cover the top as well as the bottom of the cabinet without gaps.

At least one of the first side frames and/or one of the second side frames could comprise at least one slot. In this context, at least one of the side cover arrangements could comprise at least one protrusion with corresponds to this slot or one of the slots. Alternatively, or in addition to this, the top cover arrangement and/or the bottom cover arrangement may comprise at least one protrusion corresponding to this slot or one of the slots. Corresponding means that the protrusion of the so equipped cover arrangement/s than may be inserted at least partially into the slot or one of the slots of the so equipped side frame. As a result, the so equipped cover arrangement/s may be, in particular detachably, connected to said framework.

The above mentioned wall mounted rack system according to the invention allows for a certain degree of flexibility in terms of its dimensions. At the same time, it folding into a transport state rather easily, whereby it can easily assembled on site within a very short time.

The invention is further directed to a wall mount rack which is based on an assembly respectively installation of the wall mount rack system according to the invention as previously shown.

The invention is explained in more detail below with reference to a preferred embodiment schematically illustrated in figures 1-8.
- Fig. 1: shows a wall mount rack system according to the invention in a perspective view,
- Fig. 2: depicts the parts of a framework of the wall mount rack system of figure 1,
- Fig. 3: shows the parts of the framework of figure 2 in an at least partially unfolded state of the base frame,
- Fig. 4a: illustrates the parts of the framework of figure 3 in a full unfolded state at the beginning of their assembly,
- Fig. 4b: shows the parts of figure 2 to 4a in their full unfolded and assembled state to form the framework,
- Fig. 5: depicts only the cover arrangements of the wall mount rack system of figure 1,
- Fig. 6a: shows one part of the top cover arrangement as well as the bottom cover arrangement of the cover arrangements shown figure 5 in a state fitted to the frameset of figure 4b,
- Fig. 6b: shows the framework of figure 4b together with the top and bottom cover arrangements of figure 6a mounted thereon, each in their now fully assembled state,
- Fig. 7a: illustrates one part of the side cover arrangements of the entire cover arrangements from figure 5 in a state fitted to the frameset, together with the top and bottom cover arrangements of figure 6b,
- Fig. 7b: shows the framework of figure 4b together with the top and bottom cover arrangements of figure 6a as well as the side cover arrangements mounted thereon, each side cover arrangement in its now fully assembled state, and
- Fig. 8: shows a wall mount rack according to the invention, forming a cabinet, as a result of the fully assembled wall mount rack system in a perspective view.

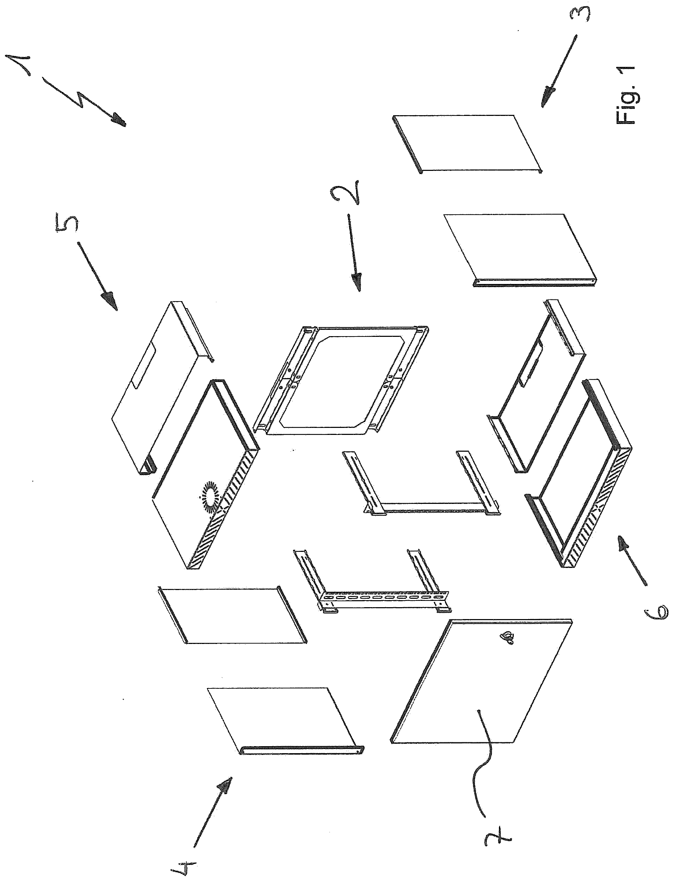

Fig. 1 shows a perspective view of a wall mount rack system 1 according to the invention. It comprises several individual parts which are shown here in the form of an exploded view. The wall mount rack system 1 essentially comprises a multipart framework 2 to serve as a support for some cover arrangements 3, 4, 5, 6 or panels and a hinged door 7.

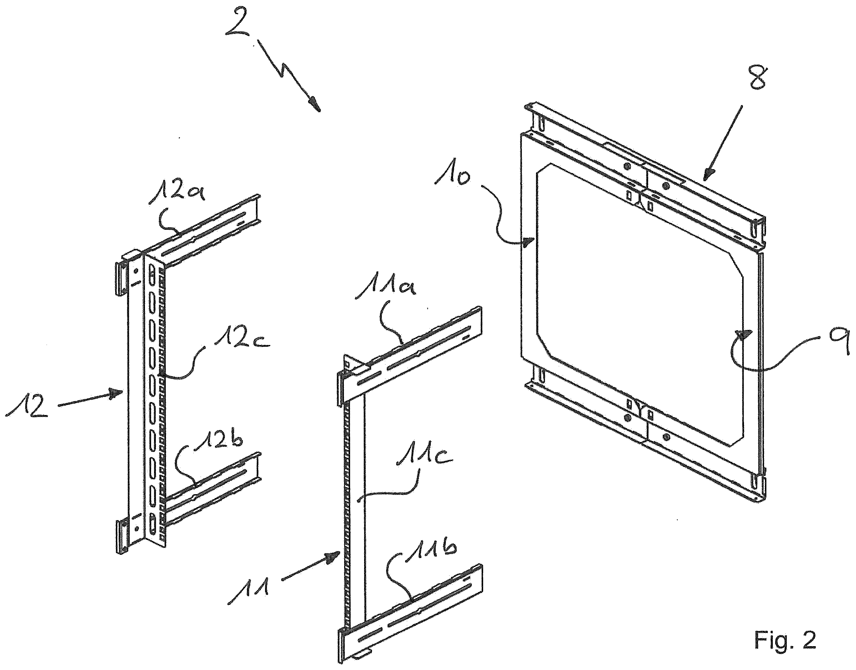

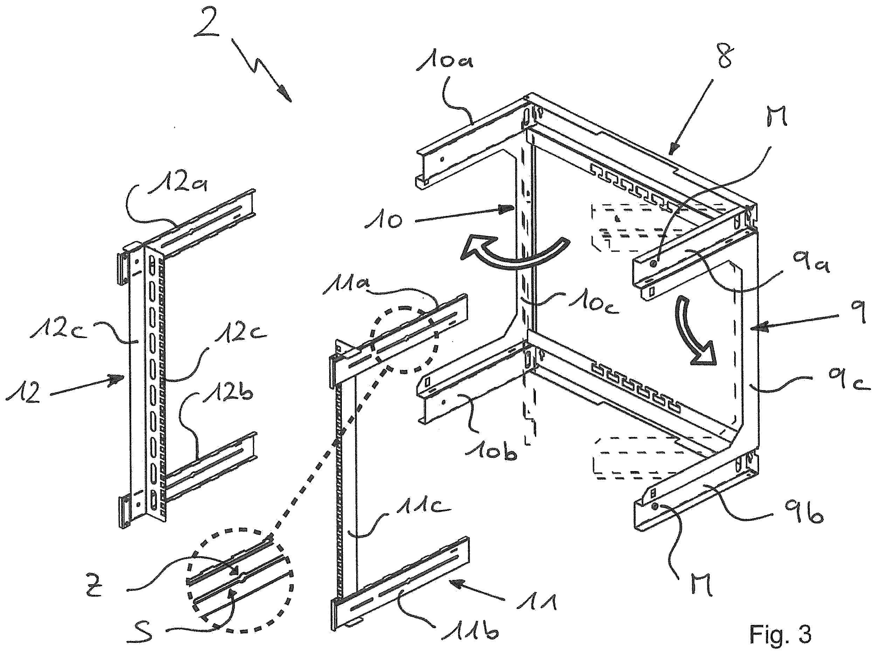

Fig. 2 illustrates the framework 2 of the wall mount rack system 1 shown in Fig. 1. The framework 2 comprises a base frame 8 as well as a first left side frame 9 and a first right side frame 10. The base frame 8 can e. g. be formed by a single rectangular frame or can e. g. feature two bars spaced apart and extending parallel to each other. Both side frames 9, 10 are each hingedly connected to the base frame 8, see Fig. 3. The framework 2 also comprises a second left side frame 11 as well as a second right side frame 12, which can be connected to the base frame 8. In the present illustration, however, both second side frames 11, 12 are shown separated from the base frame 8. Each of the second side frames 11, 12 has two arms 11a, 11b; 12a, 12b extending parallel to each other , and a crossbar 11c, 12c for connecting the arms 11a, 11b; 12a, 12b of each second side frame 11, 12 to one another.

Fig. 3 illustrates the function of the base frame 8 more in detail. It is evident that the left side frame 9 as well as the right side frame 10 can be swung out in relation to the base frame 8, as indicated by the broken lines and the two curved arrows, each illustrating a possible swinging movement of the respective side frame 9, 10. The swung-in state of the side frames 9, 10 allows for a very small packaging size of the base frame 8 during a transport and/or storage of the framework 2, wherein the swung-out state of the side frames 9, 10 serves for the proper use of the framework 2, namely to at least partially support one of the associated cover arrangements 3, 4, 5, 6, as described in more detail below.

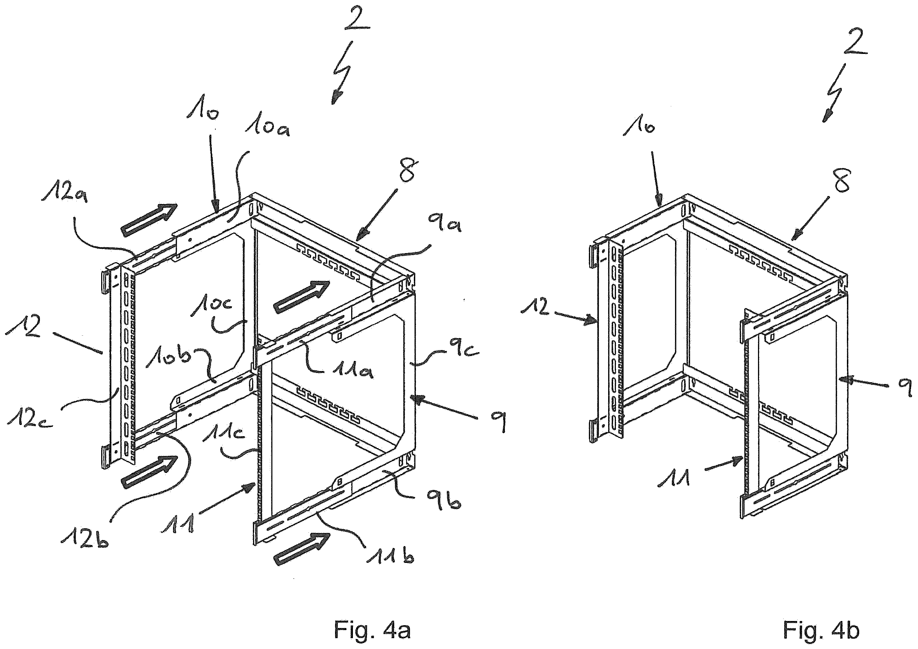

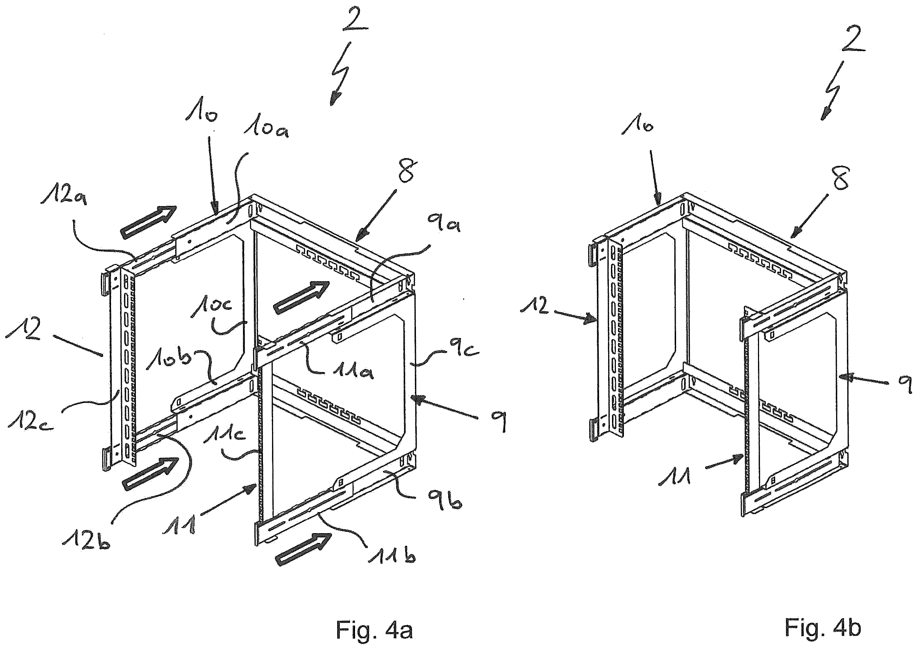

Likewise the second side frames 11, 12, each of the first side frames 9, 10 has two arms 9a, 9b; 10a, 10b extending parallel to each other , and a crossbar 9c, 10c connecting the arms 9a, 9b; 10a, 10b of each first side frame 9, 10 to one another. The arms 9a, 9b; 10a, 10b of each first side frame 9, 10 have a U-shaped cross section, at least in sections and/or regions. In contrast, the arms 11a, 11b; 12a, 12b of each second side frame 11, 12 appear more strip-shaped. Without departing from the invention it is also possible to swap the design of the arms 9a, 9b; 10a, 10b; 11a, 11b; 12a, 12b of the side frames 9, 10; 11, 12 such that the arms 9a, 9b; 10a, 10b of each first side frame 9, 10 would be strip-shaped, whereas the arms 11a, 11b; 12a, 12b of each second side frame 11, 12 would then have a U-shaped cross section, at least in sections and/or regions. In any case, the arms 11a, 11b; 12a, 12b of each second side frame 11, 12 are designed so as to each of these arms 11a, 11b; 12a, 12b can at least partially be arranged inside the U-shaped cross section of an arm 9a, 9b; 10a, 10b of the associated first side frame 9, 10 (cf. Fig. 4a and Fig. 4b).

To enable fastening, the base frame 8 is designed to fix the framework 2 to a wall (not shown), if required. For this purpose, the base frame 8 may have some passage openings P for example in the form of keyholes, as indicated in Fig. 3. Corresponding fastening means such as screws or bolts (not shown), can be fixed to the wall. The base frame 8 can then be attached the wall by passing the heads of the screws or bolts pass through the wider part of the keyholes, wherein a preferably downward movement of the base frame 8 enables the heads to slide behind the smaller part of the keyholes. The keyholes shown in Fig. 3 are preferably oriented in opposite directions to prevent the base frame from sliding down and detaching from the wall. For this purpose, the base frame 8 can simply be rotated by 180°, relative to its orientation, shown in Fig. 3 to Fig. 7b.

Taking a closer look at the arms 9a, 9b; 10a, 10b of the first side frames 9, 10, each of these arms 9a, 9b; 10a, 10b has already been equipped with an at least partially releasable connection means M. Alternatively, arms 9a, 9b; 10a, 10b could simply be prepared to receive such a connection means M. Taking a closer look at the arms 11a, 11b; 12a, 12b of the second side frames 11, 12 , each of this arms 11a, 11b; 12a, 12b is featured with an elongated slit S. With particular attention to close up portion (circle with a broken line) of the upper arm 11a of the left side frame 11 in Fig. 3, each elongated slit S has a widened hole-like zone Z.

Fig. 4a shows the process during connection of each second side frame 11, 12 to its associated first side frame 9, 10. Each hole-like zone Z of the slits S of the arms 11a, 11b; 12a, 12b of both second side frames 11, 12 is designed for passing through a head of one of the connection means M. As indicated by the arrows, during a movement of a second side frame 11, 12 relative to its associated first side frame 9, 10, an in contrast thereto smaller portion of this connection means M can at least partially slide inside the elongated slit S of the arm 11a, 11b; 12a, 12b of the second side frame 11, 12. At the same time, a portion of this arm 11a, 11b; 12a, 12b, which defines the elongated slot S, will be guided between the arm 9a, 9b; 10a, 10b of the first side frame 9, 10 and the head of the connection means M. Thus, each second side frame 11, 12 is slidably couplable to its associated first side frame 9, 10. In other words, each second side frame 11, 12 is designed to be telescoped with respect to its associated first side frame 9, 10.

Fig. 4b illustrates an end position of the second side frames 11, 12 relative to the first side frames 9, 10. In this position, the ready-to-use framework 2 has its smallest possible external dimensions. Based on the design of each arm 9a, 9b; 10a, 10b; 11a, 11b; 12a, 12b, the framework 2 is correspondingly size-flexible. By manipulating at least one of the connection means M of an arm 9a, 9b; 10a, 10b of the first side frame 9, 10, a relative movement of its associated second side frame 11, 12 can be prevented. This happens such that the associated arm 11a, 11b; 12a, 12b of this second side frame 11, 12 is then partially clamped between the arm 9a, 9b; 10a, 10b of this first side frame 9, 10 and the head of this connection means M.

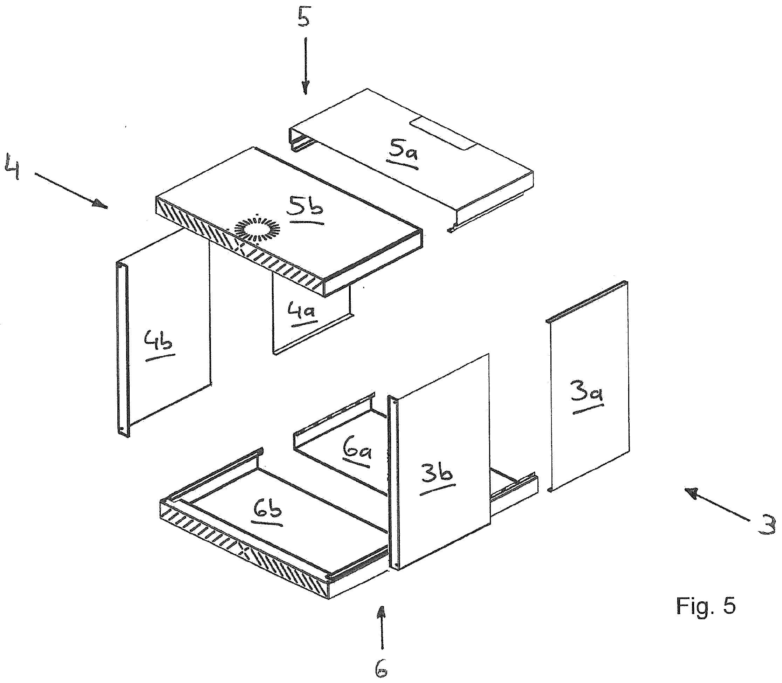

Fig. 5 shows only the cover arrangements 3 - 6 of the wall mount rack system 1 in more detail. These are in particular a left side cover arrangement 3 and a right side cover arrangement 4 as well as a top cover arrangement 5 and a bottom cover arrangement 6. Each of this cover arrangements 3 - 6 is constructed of at least two parts. Therefore, the left side cover arrangement 3 comprises a first left side cover 3a and a second left side cover 3b, whereas the right side cover arrangement comprises a first right side cover 4a and a second right side cover 4b. In addition, the top cover arrangement 5 comprises a first top side cover 5a and a second top side cover 5b, whereas the bottom cover 6 comprises a first bottom side cover 6a and a second bottom cover 6b.

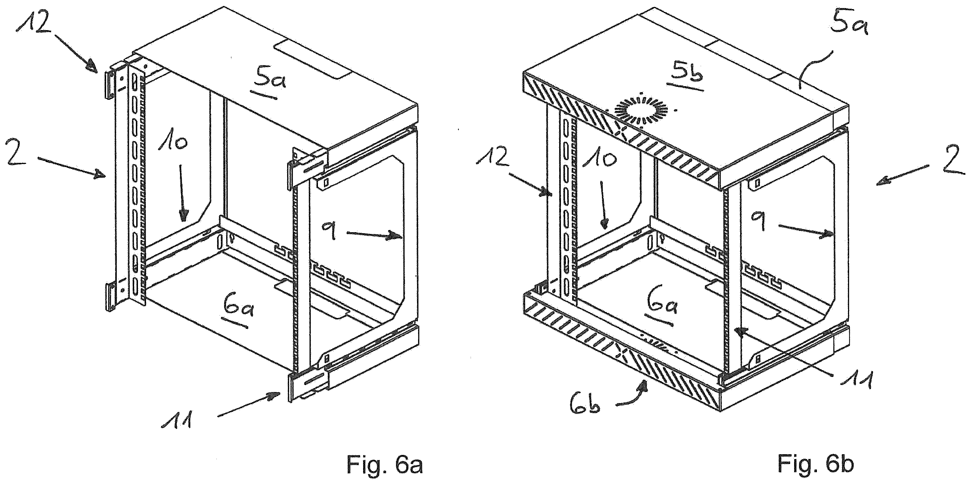

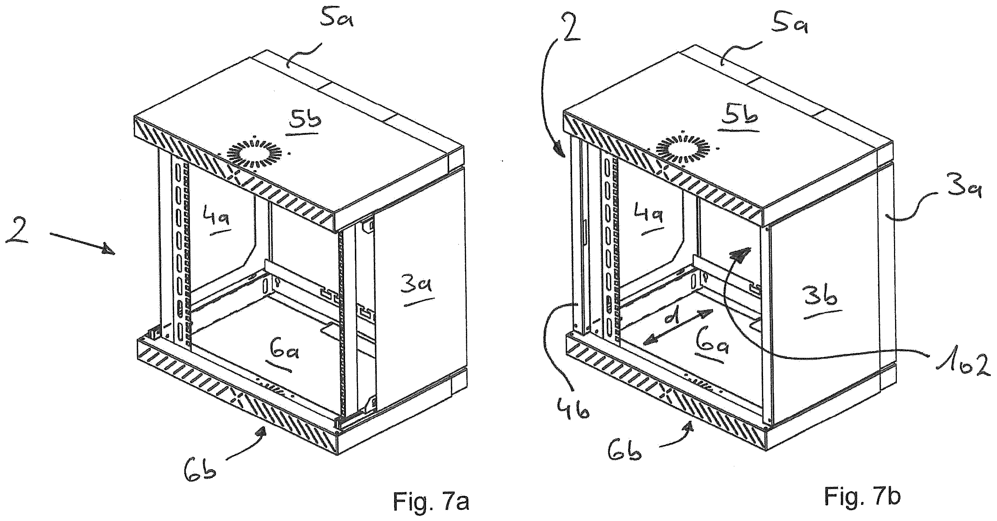

Fig. 6a and Fig. 6b as well as Fig. 7a and Fig. 7b show the assembly of the framework 2 and the cover arrangements 3 - 6. The reason for the two-part construction of the side cover arrangements 3 - 6 is that each of those is thereby flexible in size in order to go along with the possible telescoping of each second side frame 11, 12 with respect to the associated first side frame 9, 10. Each first cover arrangement 3a, 4a, 5a, 6a is designed for being coupled to both first side frames 9, 10, wherein each second cover 3b, 4b, 5b, 6b is designed for being coupled to both second side frames 11, 12. In order to accomplish this, at least one the first side frames 9, 10 and/or one of the second side frames 11, 12 may feature at least one slot (not shown), whereas at least one of the cover arrangements 3 - 6 may comprise at least one protrusion (not shown) that would fit into a slot of its associated side frame 9, 10; 11, 12. This allows for the protrusion of at least one of this cover arrangements 3 - 6 to be at least partially inserted into the slot of its associated and so equipped side frame 9, 10; 11, 12, in order to connect at least this cover arrangement 3 - 6, in particular detachably, to the framework 2. Certainly, it is possible to use other fastening means to attach at least one cover 3a, 3b; 4a, 4b; 5a, 5b; 6a, 6b of the cover arrangements 3 - 6 to the framework 2.

Fig. 6a shows the first stage of assembling the top cover arrangement 5 and the bottom cover arrangement 6 to the framework 2. During the process, the first top cover 5a is coupled to the upper arms 9a, 10a of both first side frames 9, 10, while the first bottom cover 6a is coupled to the lower arms 9b, 10b of both first side frames 9, 10.

Fig. 6b shows the final stage of assembling the top cover arrangement 5 and the bottom cover arrangement 6 to the framework 2. During the process, the second top cover 5b is coupled with the upper arms 11a, 12a of both second side frames 11, 12, while the second bottom cover 6b is coupled with the lower arms 11b, 12b of both second side frames 11, 12. The Fig. 6b shows that each second cover 5b, 6b is arranged above its associated first cover 5a, 6a.

Fig. 7a shows the first stage of assembling the side cover arrangements 3, 4 to the framework 2. The first left side cover 3a is coupled to both arms 9a, 9b of the first left side frame 9, while the first right side cover 4a is coupled to both arms 10a, 10b of the first right side frame 10.

Fig. 7b shows the final stage of assembling of the side cover arrangements 3, 4 to the framework 2. The second left side cover 3b is coupled to both arms 11a, 11b of the second left side frame 11, while the second right side cover 4b is coupled to both arms 12a, 12b of the second right side frame 12. Each second cover 3b, 4b is arranged above its associated first cover 3a, 4a.

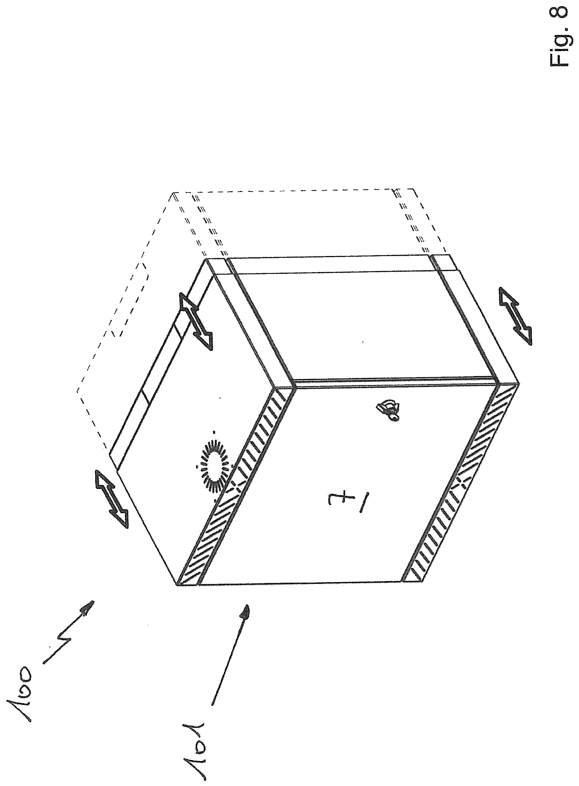

Fig. 8 illustrates a wall mount rack 100 according to the invention resulting from fully assembling the above discussed wall mount rack system 1 now finished with the hinged door 7. The wall mount rack 100 respectively the assembled wall mount rack system 1 forms a cabinet 101 which limits an interior space 102 (see Fig. 7b) for accommodating of e.g. electronic and/or network equipment modules (not shown).

Based on the structure of the so formed cabinet 101 it is possible to move each second cover 3b, 4b, 5b, 6b c in parallel to its associated first cover 3a, 4a, 5a, 6a during telescoping of the framework 2 while covering the sides of the cabinet 101 without any gaps. This flexibility in size, illustrated with arrows in Fig. 8, has advantages because the depth d (see Fig. 7b) of the so limitable interior space 102 of the cabinet 101 can be varied in any stage, namely before and/or during and/or after its assembly.

## Claims

1. Wall mount rack system (1), in particular 19-inch wall mount rack system, for accommodating electronic and/or network equipment modules, comprising a framework (2) supporting cover arrangements (3, 4, 5, 6) as well as a hinged door (7) to build a cabinet (101) which limits an interior space (102),
wherein the framework (2) and the cover arrangements (3, 4, 5, 6) are designed to be size-flexible in such a way that at least a depth (d) of the so limitable interior space (102) of the cabinet (101) can be varied before and/or after being in its fully assembled state and/or during its assembly;
wherein the framework (2) comprises a base frame (8) as well as a first left side frame (9) and a first right side frame (10), each being hinged to the base frame (8), wherein the base frame (8) is designed to fix the framework (2) to a wall and each side frame (9, 10) is intended to be swung in relative to the base frame (8), in particular during a transport and/or store of the framework (2), and to be swung out relative to the base frame (8), in particular to support at least partially one of the associated cover arrangements (3, 4, 5, 6), relative to said base frame (8), wherein a second left side frame (11) is slidably couplable to said first left side frame (9), and a second right side frame (12) is slidably couplable to said first right side frame (10), wherein each second side frame (11, 12) is designed to be telescoped with respect to the associated first side frame (9, 10) and wherein said first side frames (9, 10) and said second side frames (11, 12) each comprise two arms (9a, 9b; 10a, 10b; 11a, 11b; 12a, 12b) extending in parallel to each other, and a crossbar (9c, 10c, 11c, 12c) connecting said arms (9a, 9b; 10a, 10b; 11a, 11b; 12a, 12b) of each side frame (9-12) to one another, wherein the arms (9a, 9b; 10a, 10b; 11a, 11b; 12a, 12b) of each side frame (9-12) are designed for being slidably coupled with the arms (9a, 9b; 10a, 10b; 11a, 11b; 12a, 12b) of the associated side frame (9-12).

2. Wall mount rack system (1) according to claim 1, **characterized in that**
the arms (9a, 9b; 10a, 10b) of each first side frame (9, 10) comprise at least in sections and/or regions a U-shaped cross section, wherein the arms (11a, 11b; 12a, 12b) of each second side frame (11, 12) are designed such that each of said arms (11a, 11b; 12a, 12b) can at least partially be arranged in the U-shaped cross section of one arm (9a, 9b; 10a, 10b) of the associated first side frame (9, 10).

3. Wall mount rack system (1) according to claim 1 or 2, **characterized in**
**that** each arm (9a, 9b; 10a, 10b) of said first side frames (9, 10) is equipped with an at least partially releasable connection means (M) or is prepared to receive such a connection means (M), wherein each arm (11a, 11b; 12a, 12b) of said second side frames (11, 12) having an elongated slit (S) with a widened hole-like zone (Z), wherein each hole-like zone (Z) is designed for passing through a head of one of said connection means (M) such that during a movement of a second side frame (11, 12) relatively to an associated first side frame (9, 10), an in contrast smaller part of this connection means (M) can at least partially slide inside said elongated slit (S) of the arm (11a, 11b; 12a, 12b) of the second side frame (11, 12), while a portion of this arm (11a, 11b; 12a, 12b) of said second side frame (11, 12) defining said elongated slit (S) is guided between the arm (9a, 9b; 10a, 10b) of said first side frame (9, 10) and said head of this connection means (M).

4. Wall mount rack system (1) according to claim 3, **characterized in**
**that** a movement of a second side frame (11, 12) relative to an associated first side frame (9, 10) can be prevented by manipulating at least one of the connection means (M) of the arm (9a, 9b; 10a, 10b) of the first side frame (9, 10) such that the associated arm (11a, 11b; 12a, 12b) of this second side frame (11, 12) is partially clamped between said arm (9a, 9b; 10a, 10b) of this first side frame (9, 10) and said head of this connection means (M).

5. Wall mount rack system (1) according to any of the claims 1 to 4,
**characterized in**
**that** said left side cover arrangement (3) has a first left side cover (3a) as well as a second left side cover (3b) and that said right side cover arrangement (4) has a first right side cover (4a) as well as a second right side cover (4b), wherein each first side cover (3a, 4a) is designed for being coupled with the associated first side frame (9, 10) and each second side cover (3b, 4b) is designed for being coupled with the associated second side frame (11, 12) such that each second side cover (3b, 4b) can be moved in parallel to the associated first side cover (3a, 4a) during telescoping of the associated second side frame (11, 12) with respect to the associated first side frame (9, 10).

6. Wall mount rack system (1) according to any of the claims 1 to 5,
**characterized in**
**that** the top cover arrangement (5) has a first top cover (5a) as well as a second top cover (5b) and that the bottom cover arrangement (6) has a first bottom cover (6a) as well as a second bottom cover (6b), wherein the first top cover (5a) as well as the first bottom cover (6a) are designed for being coupled with the associated first side frames (9, 10) and the second top cover (5b) as well as the second bottom cover (6b) are designed for being coupled with the associated second side frames (11, 12) such that the second top cover (5b) can be moved in parallel to the associated first top cover (5a) and that the second bottom cover (6b) can be moved in parallel to the associated first bottom cover (6a) during telescoping of the second side frames (11, 12) with respect to the associated first side frames (9, 10).

7. Wall mount rack system (1) according to any of the claims 1 to 6,
**characterized in**
**that** at least one said first side frames (9, 10) and/or one of said second side frames (11, 12) comprises at least one slot, wherein at least one of said side cover arrangements (3, 4) and/or said top cover arrangement (5) and/or said bottom cover arrangement (6) comprises at least one protrusion corresponding to this slot in such a way that the protrusion of at least one of this cover arrangements (3 - 6) can at least partially be inserted into the slot of the so equipped side frame (9, 10; 11, 12) in order to connect at least this cover arrangement (3 - 6), in particular detachably, to said framework (2).

8. Wall mount rack (100), comprising an assembly of the wall mount rack system (1) according to any one of the preceding claims.

## Patentansprüche

1. Wandmontage-Racksystem (1), insbesondere 19-Zoll-Wandmontage-Racksystem, zur Aufnahme von elektronischen und/oder netzwerktechnischen Gerätemodulen, mit einem Gestell (2), das Abdeckanordnungen (3, 4, 5, 6) sowie eine Schwenktür (7) trägt, um einen Schrank (101) auszubilden, der einen Innenraum (102) begrenzt,
wobei das Gestell (2) und die Abdeckanordnungen (3, 4, 5, 6) derart größenflexibel ausgebildet sind, dass zumindest eine Tiefe (d) des so begrenzbaren Innenraums (102) des Schranks (101) vor und/oder nach seinem vollständig montierten Zustand und/oder während seiner Montage variiert werden kann;
wobei das Gestell (2) einen Grundrahmen (8) sowie einen ersten linken Seitenrahmen (9) und einen ersten rechten Seitenrahmen (10) aufweist, die jeweils gelenkig mit dem Grundrahmen (8) verbunden sind, wobei der Grundrahmen (8) dazu ausgebildet ist, das Gestell (2) an einer Wand zu befestigen, und jeder Seitenrahmen (9, 10) dazu vorgesehen ist, insbesondere bei einem Transport und/ oder einer Lagerung des Gestells (2), relativ zum Grundrahmen (8) eingeschwenkt und relativ zum Grundrahmen (8) ausgeschwenkt zu werden, um insbesondere zumindest teilweise eine der zugehörigen Abdeckanordnungen (3, 4, 5, 6) gegenüber dem Grundrahmen (8) abzustützen, wobei ein zweiter linker Seitenrahmen (11) verschiebbar mit dem ersten linken Seitenrahmen (9) und ein zweiter rechter Seitenrahmen (12) verschiebbar mit dem ersten rechten Seitenrahmen (10) koppelbar ist, wobei jeder zweite Seitenrahmen (11, 12) gegenüber dem zugehörigen ersten Seitenrahmen (9) teleskopierbar ausgebildet ist und wobei die ersten Seitenrahmen (9, 10) und die zweiten Seitenrahmen (11, 12) jeweils zwei Arme (9a, 9b; 10a, 10b; 11a, 11b; 12a, 12b), die sich parallel zueinander erstrecken, und eine Querstange (9c, 10c, 11c, 12c) umfassen, die die Arme (9a, 9b; 10a, 10b; 11a, 11b; 12a, 12b) jedes Seitenrahmens (9-12) miteinander verbindet, wobei die Arme (9a, 9b; 10a, 10b; 11a, 11b; 12a, 12b) jedes Seitenrahmens (9-12) so ausgebildet sind, dass sie mit den Armen (9a, 9b; 10a, 10b; 11a, 11b; 12a, 12b) des zugehörigen Seitenrahmens (9-12) verschiebbar gekoppelt sind.

2. Wandmontage-Racksystem (1) nach Anspruch 1,
**dadurch gekennzeichnet,**
**dass** die Arme (9a, 9b; 10a, 10b) jedes ersten Seitenrahmens (9, 10) zumindest abschnittsweise und/oder bereichsweise einen U-förmigen Querschnitt aufweisen, wobei die Arme (11a, 11b; 12a, 12b) jedes zweiten Seitenrahmens (11, 12) so ausgebildet sind, dass jeder dieser Arme (11a, 11b; 12a, 12b) zumindest teilweise in dem U-förmigen Querschnitt eines Armes (9a, 9b; 10a, 10b) des zugehörigen ersten Seitenrahmens (9, 10) angeordnet werden kann.

3. Wandmontage-Racksystem (1) nach Anspruch 1 oder 2, **dadurch gekennzeichnet,**
**dass** jeder Arm (9a, 9b; 10a, 10b) der ersten Seitenrahmen (9, 10) mit einem zumindest teilweise lösbaren Verbindungsmittel (M) ausgestattet oder zur Aufnahme eines solchen Verbindungsmittels (M) vorbereitet ist, wobei jeder Arm (11a, 11b; 12a, 12b) der zweiten Seitenrahmen (11, 12) einen länglichen Schlitz (S) mit einer erweiterten lochartigen Zone (Z) aufweist, wobei jede lochartige Zone (Z) dazu ausgelegt ist, dass der Kopf eines der Verbindungsmittel (M) hindurchgeführt werden kann, so dass während einer Bewegung eines zweiten Seitenrahmens (11, 12) relativ zu einem zugehörigen ersten Seitenrahmen (9, 10) ein demgegenüber kleinerer Teil dieses Verbindungsmittels (M) zumindest teilweise in den länglichen Schlitz (S) des Arms (11a, 11b; 12a, 12b) des zweiten Seitenrahmens (11, 12) verschoben werden kann, während ein Abschnitt dieses Arms (11a, 11b; 12a, 12b) des zweiten Seitenrahmens (11, 12), der den länglichen Schlitz (S) definiert, zwischen dem Arm (9a, 9b; 10a, 10b) des ersten Seitenrahmens (9, 10) und dem Kopf dieses Verbindungsmittels (M) geführt wird.

4. Wandmontage-Racksystem (1) nach Anspruch 3,
**dadurch gekennzeichnet**
**dass** eine Bewegung eines zweiten Seitenrahmens (11, 12) relativ zu einem zugehörigen ersten Seitenrahmen (9, 10) derart verhindert werden kann, dass der zugehörige Arm (11a, 11b; 12a, 12b) dieses zweiten Seitenrahmens (11, 12) teilweise zwischen dem Arm (9a, 9b; 10a, 10b) dieses ersten Seitenrahmens (9, 10) und dem Kopf dieses Verbindungsmittels (M) eingeklemmt wird.

5. Wandmontage-Racksystem (1) nach einem der Ansprüche 1 bis 4,
**dadurch gekennzeichnet**
**dass** die linke Abdeckanordnung (3) eine erste linke Seitenabdeckung (3a) sowie eine zweite linke Seitenabdeckung (3b) aufweist und dass die eine rechte Abdeckanordnung (4) eine erste rechte Seitenabdeckung (4a) sowie eine zweite rechte Seitenabdeckung (4b) aufweist, wobei jede erste Seitenabdeckung (3a, 4a) zur Kopplung mit dem zugehörigen ersten Seitenrahmen (9, 10) und jede zweite Seitenabdeckung (3b, 4b) zur Kopplung mit dem zugehörigen zweiten Seitenrahmen (11, 12) derart ausgebildet ist, dass jede zweite Seitenabdeckung (3b, 4b) beim Teleskopieren des zugehörigen zweiten Seitenrahmens (11, 12) gegenüber dem zugehörigen ersten Seitenrahmen (9, 10) parallel zur zugehörigen ersten Seitenabdeckung (3a, 4a) bewegt werden kann.

6. Wandmontage-Racksystem (1) nach einem der Ansprüche 1 bis 5,
**dadurch gekennzeichnet**
**dass** die obere Abdeckanordnung (5) eine erste obere Abdeckung (5a) sowie eine zweite obere Abdeckung (5b) aufweist und dass die untere Abdeckanordnung (6) eine erste untere Abdeckung (6a) sowie eine zweite untere Abdeckung (6b) aufweist, wobei die erste obere Ab-deckung (5a) sowie die erste untere Abdeckung (6a) zur Kopplung mit den zugehörigen ersten Seitenrahmen (9, 10) ausgebildet sind und die zweite obere Abdeckung (5b) sowie die zweite untere Abdeckung (6b) mit den zugehörigen zweiten Seitenrahmen (11, 12) derart koppelbar sind, dass die zweite obere Abdeckung (5b) parallel zu der zugehörigen ersten oberen Abdeckung (5a) und die zweite untere Abdeckung (6b) parallel zu der zugehörigen ersten unteren Abdeckung (6a) beim Teleskopieren der zweiten Seitenrahmen (11, 12) gegenüber den zugehörigen ersten Seitenrahmen (9, 10) bewegbar ist.

7. Wandmontage-Racksystem (1) nach einem der Ansprüche 1 bis 6,
**dadurch gekennzeichnet**
**dass** mindestens einer der ersten Seitenrahmen (9, 10) und/oder einer der zweiten Seitenrahmen (11, 12) mindestens einen Schlitz aufweist, wobei mindestens eine der seitlichen Abdeckanordnungen (3, 4) und/oder die obere Abdeckanordnung (5) und/oder die untere Abdeckanordnung (6) mindestens einen mit diesem Schlitz korrespondierenden Vorsprung aufweist, derart, dass der Vorsprung mindestens einer dieser Abdeckanordnungen (3 - 6) zumindest teilweise in den Schlitz des so ausgerüsteten Seitenrahmens (9, 10; 11, 12) eingeführt werden kann, um zumindest diese Abdeckanordnung (3 - 6), insbesondere lösbar, mit dem Gestell (2) zu verbinden.

8. Wandmontage-Rack (100), umfassend eine Anordnung des Wandmontage-Racksystems (1) nach einem der vorhergehenden Ansprüche.

## Revendications

1. Système de rack de montage mural (1), surtout un système de rack de montage mural de 19 pouces, pour recevoir des modules d'équipement électronique et/ou de réseau comportant un cadre (2) supportant des ensembles de couverture (3, 4, 5, 6) ainsi qu'une porte pivotante (7) pour former un cabinet (101) limitant un espace intérieur (102),
dans lequel le cadre (2) et les ensembles de couvertures (3, 4, 5, 6) sont conçus pour être flexibles en termes de taille, de manière à ce qu'au moins une profondeur (d) de l'espace intérieur (102) si limitée du cabinet (101) peut être modifiée avant et/ ou après avoir été entièrement assemblé et/ou pendant son montage;
dans lequel le cadre (2) comporte un cadre de base (8) ainsi qu'un premier cadre latéral gauche (9) et un premier cadre latéral droit (10) qui sont articulés au cadre de base (8), dans lequel le cadre de base (8) est conçu pour fixer le cadre (2) à un mur, et chaque cadre latéral (9, 10) est prévu pour être pivoté vers l'intérieur par rapport au cadre de base (8) et pour être pivoté vers l'extérieur par rapport au cadre de base (8), en particulier lors d'un transport et/ou d'un stockage du cadre (2) pour, au moins partiellement, supporter, au moins partiellement, l'une des ensembles de couvertures (3, 4, 5, 6) associés par rapport au cadre de base (8), dans lequel un deuxième cadre latéral gauche (9) et un deuxième cadre latéral droit (12) est couplable par glissement au premier cadre latéral gauche (9), et un deuxième cadre latéral droit (12) est couplable par glissement au premier cadre latéral droit (10), dans lequel chaque deuxième cadre latéral (11, 12) est conçu pour être télescopé par rapport au premier cadre latéral (9) associé, et dans lequel les premiers cadres latéraux (9) et les deuxièmes cadres latéraux (11, 12) chacun comportent deux bras (9a, 9b; 10a; 10b; 11a, 11b; 12a, 12b) s'étendant parallèlement les uns aux autres ainsi qu'une barre transversale (9c, 10c, 11c, 12c) reliant les bras (9a, 9b; 10a; 10b; 11a, 11b; 12a, 12b) de chaque cadre latéral (9 à 12) les uns aux autres, dans lequel les bras (9a, 9b; 10a; 10b; 11a, 11b; 12a, 12b) de chaque cadre latéral (9 à 12) sont conçus pour être couplés de manière coulissante aux bras (9a, 9b; 10a; 10b; 11a, 11b; 12a, 12b) du cadre latéral (9 à 12) associé.

2. Système de rack de montage mural (1) selon la revendication 1,
**caractérisé en ce**
**que** les bras (9a, 9b; 10a; 10b; 11a, 11b; 12a, 12b) de chaque premier cadre latéral (9, 10) comportent une section transversale en U, au moins par sections et/ou par régions, dans lequel les bras (9a, 9b; 10a; 10b; 11a, 11b; 12a, 12b) de chaque deuxième cadre latéral (11, 12) sont conçus de telle sorte que chacun de ses bras (11a, 11b; 12a, 12b), au moins partiellement, peut être agencé dans la section transversale en U d'un bras (9a, 9b; 10a; 10b) du premier cadre latéral (9) associé.

3. Système de rack de montage mural (1) selon la revendication 1 ou 2,
**caractérisé en ce**
**que** chaque bras (9a, 9b; 10a; 10b; 11a, 11b; 12a, 12b) des premiers cadres latéraux (9, 10) est équipé d'un moyen de liaison (M), au moins partiellement amovible, ou est préparé pour recevoir un tel moyen de liaison (M), dans lequel chaque bras (11a, 11b; 12a, 12b) des deuxièmes cadres latéraux (11, 12) comporte une fente allongée (S) avec une zone élargie semblable à un trou (Z), dans lequel chaque zone semblable à un trou (Z) est conçue pour pouvoir faire passer la tête de l'un des moyens de liaison (M), de sorte que, pendant un mouvement d'un deuxième cadre latéral (11, 12) par rapport à un premier cadre latéral (9) associée, une partie en revanche plus petite de ce moyen de liaison (M) peut être déplacée, au moins partiellement, dans la fente allongée (S) du bras (11a, 11b; 12a, 12b) du deuxième cadre latéral (11, 12), tandis qu'une section de ce bras (11a, 11b; 12a, 12b) du deuxième cadre latéral (11, 12) définissant la fente allongée (S) est guidée entre le bras (9a, 9b; 10a; 10b) du premier cadre latéral (9, 10) et la tête de ce moyen de liaison (M).

4. Système de rack de montage mural (1) selon la revendication 3,
**caractérisé en ce**
**qu'**un mouvement d'un deuxième cadre latéral (11, 12) par rapport à un premier cadre latéral (9) associé peut être empêché de telle manière que le bras (11a, 11b; 12a, 12b) associé de ce deuxième cadre latéral (11, 12) est partiellement serré entre le bras (9a, 9b; 10a; 10b) de ce premier cadre latéral (9, 10) et la tête de ce moyen de liaison (M).

5. Système de rack de montage mural (1) selon l'une quelconque des revendications 1 à 4,
**caractérisé en ce**
**que** l'ensemble de couverture gauche (3) comporte une première couverture latérale gauche (3a) ainsi qu'une deuxième couverture latérale gauche (3b) et que ledit ensemble de couverture droite (4) comporte une première couverture latérale droite (4a) ainsi qu'une deuxième couverture latérale droite (4b), dans lequel chaque première couverture latérale (3a, 4a), pour couplage au premier cadre latéral (9, 10) associée, et chaque deuxième couverture latérale (3b, 4b), pour couplage au deuxième cadre latéral (11, 12) associé, est formée de telle manière que chaque deuxième couverture latérale (3b, 4b), pendant le télescopage du deuxième cadre latéral (11, 12) associé, par rapport au premier cadre latéral (9, 10) associé, peut être déplacée parallèlement à la première couverture latérale (3a, 4a) associée.

6. Système de rack de montage mural (1) selon l'une quelconque des revendications 1 à 5,
**caractérisé en ce**
**que** l'ensemble de couverture supérieure (5) comporte une première couverture supérieure (5a) ainsi qu'une deuxième couverture supérieure (5b) et que l'ensemble de couverture inférieur (6) comporte une première couverture inférieure (6a) ainsi qu'une deuxième couverture inférieure (6b), dans lequel la première couverture supérieure (5a) ainsi que la première couverture inférieure (6a) est conçue pour être couplée aux premiers cadres latéraux (9) associés, et la deuxième couverture supérieure (5b) ainsi que la deuxième couverture inférieure (6b) peuvent être couplés aux deuxièmes cadres latéraux (11, 12) associés de telle manière que la deuxième couverture supérieure (5b) est déplaçable parallèlement à la première couverture supérieure (5a) associée, et que la deuxième couverture inférieure (6b) est déplaçable parallèlement à la première couverture inférieure (6a) associée lors du télescopage des deuxièmes cadres latéraux (11, 12) par rapport aux premiers cadres latéraux (9, 10) associés.

7. Système de rack de montage mural (1) selon l'une quelconque des revendications 1 à 6,
**caractérisé en ce**
**qu'**au moins un des premiers cadres latéraux (9 à 10) et/ou un des deuxièmes cadres latéraux (11, 12) comporte au moins une fente, dans lequel au moins un des ensembles de couverture latérale (3, 4) et/ou l'ensemble de couverture supérieure (5) et/ou l'ensemble de couverture inférieur (6) comporte au moins une saillie correspondant à cette fente de telle manière que la saillie de l'au moins un de ces ensembles de couverture (3 à 6) peut être inséré au moins partiellement dans la fente du cadre latéral (9, 10; 11, 12) ainsi équipé pour relier, surtout de manière détachable, au moins cet ensemble de couverture (3 à 6) au cadre (2).

8. Rack de montage mural (100) comportant un ensemble du système de rack de montage mural (1) selon l'une quelconque des revendications précédentes.
